# EUROPEAN PATENT APPLICATION

(11) **EP 4 832 052 A1**
(43) Date of publication of application: **28.10.2026**
(21) Application number: 25171652.8
(22) Date of filing: 22.04.2025
(51) Int. Cl.: H01L 21/3065

(54) **PROCESSING OF A NANOSTRUCTURE**

(71) Applicant: AlixLabs AB, 223 63 Lund (SE)
(72) Inventor: SUYATIN, Dmitry, 224 72 Lund (SE); MUHAMMAD, Asif, 222 74 Lund (SE); ROOZEBOOM, Freddy, 5582 ED Waalre (NL); SUNDQVIST, Jonas Valdemar, 01328 Dresden (DE)
(74) Representative: Zacco Sweden AB

(57) **Abstract**

A method for splitting a 3D nanostructure erecting from a support structure is presented. The portion of the nanostructure erecting from the planar support structure is having a main surface delimited by, in relation to the main surface, inclined surfaces. The inclined surfaces are extending from the main surface to a top surface of the support structure. The method comprises subjecting the nanostructure for a first cyclic process. Each cycle of the first cyclic process comprises: coating the main surface and the inclined surfaces with a coating layer; applying a first etching process configured to anisotropically etch the coating layer from the main surface while preserving the coating layer on the inclined surfaces, thereby exposing the main surface of the nanostructure; and applying a second etching process configured to selectively etch the exposed main surface of the nanostructure using the coating layers of the inclined surfaces as masking layers. Whereby selective etching of the main surface relative to the inclined surfaces is achieved such that a recess in the nanostructure is formed, the recess having its opening at the main surface of the nanostructure.

## Description

### TECHNICAL FIELD

The present invention relates to the formation of nanostructures. More precisely, to splitting of nanostructures being arranged on a support structure.

### BACKGROUND ART

The interest in manufacturing devices, e.g. advanced semiconductor devices, having dimensions below 100 nm is constantly growing. Today a lateral size of advanced semiconductor devices, i.e. electronic components such as transistors, is already at and even below 20 nm. However, fabrication of structures with lateral size below 20 nm is hard to achieve with present processes. For instance, the spatial resolution of ultraviolet lithography, UVL, which is commonly used for manufacturing semiconductor devices in industry, is limited. Therefore, alternative approaches are required to overcome such challenges and to allow fabrication of nanostructures with a lateral size below 20 nm.

Therefore, a number of technologies are under development to allow fabrication of nanostructures with lateral size below 20 nm. Some examples are Extreme Ultra-Violet lithography (EUV-L), Self-Aligned Multi-Patterning, Electron-beam Direct-Write, Nano-Imprint Lithography, and Directed Self-Assembly.

Today, Extreme Ultra-Violet lithography is the most advanced direct patterning method in high volume manufacturing. However, Extreme Ultra-Violet lithography suffers from very thin resist layers, and it is usually difficult to achieve targeted line edge roughness (LER) and line width roughness (LWR) with this patterning technology. Self-aligned patterning is a complementary patterning technique that is widely used when the optical lithography cannot provide the resolution that is required. This self-aligned patterning also has some technical limitations and involves multiple processing steps, driving the associated patterning costs. Often, it has a limited yield and throughput.

In view of the above, there is room for improvement in fabrication of nanostructures, especially the fabrication of nanostructures with lateral size below 20 nm.

### SUMMARY OF THE INVENTION

The present invention is set out in the appended set of claims.

A method for processing a nanostructure having a main surface delimited by, in relation to the main surface, inclined surfaces is provided. The processing results in splitting of the nanostructure. The nanostructure being a 3D structure erecting from a planar support structure. It is the portion of the nanostructure erecting from the planar support structure that has the main surface and the inclined surfaces. The main surface is typically parallel to the planar support structure. The inclined surfaces are extending from the main surface down to a top surface of the support structure. The method comprises subjecting the nanostructure for a first cyclic process. Each cycle of the first cyclic process comprises: coating the main surface and the inclined surfaces with a coating layer; applying a first etching process configured to anisotropically etch the coating layer from the main surface while preserving the coating layer on the inclined surfaces, thereby exposing the main surface of the nanostructure; next, applying a second etching process configured to selectively etch the exposed main surface of the nanostructure using the coating layers of the inclined surfaces as masking layers. Whereby selective etching of the main surface relative to the inclined surfaces is achieved such that a recess in the nanostructure is formed, the recess having its opening at the main surface of the nanostructure.

According to the presented method for splitting a nanostructure, multiple separate processes as used in the prior art, are integrated into one process as different process steps. This provides for improved process control, reduces operating expenses (OpEx), and capital expenditures (CapEx), while improving the throughput. Especially, the increased process control is provided by utilizing a cyclic processing where different processing effects dominate in different steps. Further, the process control and the multiple-step integration are enabled by introducing the first and second etching processes within each cycle in the cyclic processing. In the first and second etching processes, surface modification and etch processes are done differently. That is, with different process selectivity. Hence, by utilizing a cyclic processing, where different processes dominate in different steps of each cycle in the cyclic process, control is enabled so that a recess may be formed in the nanostructure subjected for the cyclic processing. By the proposed cyclic processing, the number of process steps may be decreased as compared with the conventional processing of nanostructures. This facilitates an increase in the throughput and provides for making production more economical. The proposed process facilitates pushing of the resolution limits, this since the number of defects in the produced nanostructures may be reduced. The proposed processing method may even heal some imperfections of incoming structures and thus maintain the so-called shape fidelity of the intended patterns. All this by relying on changes in already existing equipment and processes, saving time and resources for the industry. It is further to be noted that the presented method for splitting the nanostructure is performed without using a patterned mask.

The first etching process and the second etching process may be different etching processes. For example, the first etching process may be performed by etching with a first type of ions impinging the nanostructure, and the second etching process may be performed by etching with a second type of ions impinging the nanostructure. The first and second types of ions being different types of ions. The first type of ions may be from highly chemically reactive plasma gases containing halogens like SF₆, Cl₂, CHCl₃. The second type of ions may be, as compared to the first type of ions less chemically reactive plasma gases, containing compounds, like Br₂, HBr, H₂. Alternatively, the second type of ions may be elemental plasma gases containing Ar, Ne, N2, that mostly or fully sputter off one surface monolayer. Further alternatively, the second type of ions may be O₂ or O₃ gases that combust off one or more surface monolayers.

Forming the coating layer on the main surface and the inclined surfaces, i.e. the coating may be performed such that all surfaces of the nanostructure erecting from the support structure comprise a coating layer.

The coating may be performed using atomic layer deposition (ALD) or chemical vapor deposition (CVD), or other thin film coating techniques. Using ALD, a very precise control of the deposited layer as a function of the process cycles is provided. Further, atomic layer deposition provides a uniform coating to be made on two-dimensional as well as three-dimensional patterned features.

The coating may be made by a material selected from the group of materials consisting of silicon oxide, TiO2, TaN, TaON, Al₂O₃, HfO₂, ZrO₂, silicon nitride, silicon carbonitride, amorphous silicon, silicon oxycarbide, silicon oxychloride, silicon oxyfluoride, and polymers, such as fluorocarbon, boron-rich fluorocarbon, chlorocarbon, boron-reach fluorocarbon or hydrocarbon, chlorinated or boron-doped hydrocarbon polymer, or a combination thereof.

The first etching process may be performed by reactive ion etching with ions having a first kinetic energy upon impinging the nanostructure. The second etching process may be performed by reactive ion etching with ions having a second kinetic energy upon impinging the nanostructure. The second kinetic energy is lower than the first kinetic energy. Hence, reactive ion etching may be used for both the first and second etching processes, the kinetic energy of the ions being different for the two processes.

The ions in the reactive ion etching of the first etching process may be formed from ionized SF₆ gas contained in a gas mixture supplied to the process chamber volume. It is also to be understood that other ionized etch gas mixtures may be used, such as HF₃, CₓH_{y}F_{z}, Cl₂, BCl₃, and CHCl₃.

The ions in the reactive ion etching of the second etching process may be formed from ionized SF₆ gas contained in a gas mixture supplied to the process chamber volume. It is also to be understood that other ionized etch gas mixtures may be used, such as HF₃, CₓH_{y}F_{z}, Cl₂, BCl₃, and CHCl₃.

The first etching process may be performed by reactive ion etching and the second etching process may be a second cyclic etching process, where each cycle comprises surface modification by introducing chemical species in a process chamber volume enclosing the nanostructure and surface activation removal by noble gas ion bombardment. Hence, a continuous etch process in the form of reactive ion etching may be used for the first etching process, and a cyclic etching process may be used for the second etching process. The reactive ion etching may be done using ionized SF₆ gas contained in a gas mixture supplied to the process chamber volume. In the second cyclic etching process the noble gas may be argon. The chemical species used in the surface modification of the second cyclic etching process may be halogens. The surface modification of the second cyclic etching process may be done in a gas phase that contains only neutral chemical species. More specifically, the surface modification of the second cyclic etching process may be done by chlorine chemisorption. The surface modification of the second cyclic etching process may be followed by an evacuation of excessive chemical species from the process chamber volume.

At least a portion, preferably each, of the cycles of the first cyclic process may further comprise purging a process chamber volume used for the processing of the nanostructure by flushing the process chamber volume with a gas mixture. The gas mixture used for flushing is containing oxygen or an inert gas, e.g. argon, or a mixture thereof. The flushing may be performed for 0.001-30 seconds or may be even omitted. This step may be performed at 0.01-100 mTorr, preferably 0.1-3 mTorr, process pressure, and at 10-200 sccm, preferably 30-50 sccm, gas flow.

The nanostructure may be arranged on a support structure. The support structure may be formed of various materials. The support structure may be a stop layer.

The number of cycles in the first cyclic process may be in the range of 1 to 200 cycles.

The nanostructure may be formed from various materials. Especially, the nanostructure may be made from a material selected from silicon (amorphous silicon, crystalline silicon, silicon carbide, or polycrystalline silicon), silicon nitride (e.g. Si₃N₄), silicon oxide (e.g. SiO₂), silicon oxynitride, amorphous carbon and polymers, such as polysiloxanes or polysilazanes. The nanostructure may also be made of EUV (extreme ultraviolet) sensitive Metal Oxide resist (MOR). Other types of materials may also be used for the nanostructure.

The method may be performed at temperatures ranging from -120°C up to 300°C, preferably -120°C up to 35°C.

The first process may be performed with gas mixtures containing only gases with low global warming potential, such as non-fluorine containing halogens, such as Cl₂, BCl₃, combined with other low global warming potential gases such as Ar, O₂, H₂.

The method may be performed such that the surface roughness is reduced due to the multiple deposition and etch-back, which are optimized in such a way that the deposition and the etch-back steps are quasi-ALD and quasi-ALE.

The reactive ion etching may be made using ionized SF₆ gas, admixed with a few % (up to ~10 %) oxygen gas, to remove or suppress the SOₓF_{y} that is formed parasitically on reactor chamber walls.

One or more of the cyclic processes discussed above may be realized through pulses.

The cyclic processes may overlap and/or merge, ultimately leading to multiplexed processes and continuous processes in which required reactions and processes are controlled as necessary. The processes may include a dynamic process parameter morphing during the process in such way that the etching parameters change as needed during the process. According to some examples as specific process may comprise starting the process as a continuous dry etch process, and then ending it in a cyclic way to ensure a high-performance dry etch process. An aspect of this parameter morphing is that it may be guided by real-time feedback from the process monitoring, which can be done in situ or ex-situ using e.g. optical emission spectroscopy and/or residual gas analyzer. One or more of the cyclic processes discussed above may comprise an atomic layer etching process. Especially, one or more of the cyclic processes discussed above may be an atomic layer etching process.

By a cyclic etching process is meant a process that includes a series of events or processes that repeat in a predictable pattern. It typically comprises a sequence of stages or phases that occur in a specific order and return to the starting point upon completion. The cycles may include various pulses or consist of pulses.

By a pulse is meant a brief, sudden change in a physical quantity, often followed by a return to its original state.

By atomic layer etching, ALE, is meant an etching technique that uses sequential half-reactions resulting in layer-by-layer material subtraction. The ALE implementation comprises at least two sequential steps: surface modification (reaction A) and removal (reaction B). These reactions can be cycled, and at least one step is at least partly self-limiting. The modification step forms a thin reactive surface layer with a well-defined thickness that is subsequently more easily removed than the unmodified material. The layer is characterized by a change in chemical composition and/or material structure. Removal methods include thermal desorption, particle bombardment, and chemical reaction. Here in the ALE processes, we also include quasi-atomic layer etching processes, which may include quasi-self-limiting reactions and non-self-limiting reactions.

By self-limiting reactions is meant reactions that slow down or stop as a function of time or, equivalently, as a function of species dosage. Self-limiting reactions may include, but are not limited to deposition, chemisorption, physisorption, conversion (e.g., oxidation, nitridation), and extraction. In the extraction case, the original material is a compound, with the modification removing one element preferentially from the surface, while the other element is removed in the subsequent removal step.

### BRIEF DESCRIPTION OF THE DRAWINGS

The above and other aspects will now be described in more detail, with reference to appended figures. The figures should not be considered limiting; instead, they are used for explaining and understanding.

As illustrated in the figures, the sizes of layers and regions may be exaggerated for illustrative purposes and, thus, are provided to illustrate the general structures. Like reference numerals refer to like elements throughout.
Fig. 1 schematically illustrates a nanostructure to be exposed to the processing disclosed herein.
Fig. 2 is a block diagram of a method for processing a nanostructure.
Fig. 3, comprising Figs 3A-3G, schematically illustrates results after process steps in the method of Fig. 2.

### DETAILED DESCRIPTION

The present invention will now be described more fully hereinafter with reference to the accompanying drawings, in which currently preferred embodiments of the invention are shown. This invention may, however, be embodied in many different forms.

The present invention is directed towards a method for processing a nanostructure. Especially, the present invention is directed towards selective etching of a main surface of the nanostructure relative to inclined surfaces of the nanostructure. Such processing will result in splitting of the nanostructure. Accordingly, the present invention allows for a pitch split of an array of nanostructures.

The nanostructure may be made from a material selected from a group of materials consisting of silicon, silicon nitride, silicon oxide, silicon carbide, amorphous carbon, and polymers, such as polysiloxanes or polysilazanes or any photo sensitive or electron beam sensitive polymer or a polymer used for printing in nanoimprint lithography, as an example. Additionally, the nanostructure may be made from any low-k dielectric, such as silicon oxynitride, or any high-k dielectric layer, such as hafnium oxide, zirconium oxide, titanium oxide, tantalum oxide, or aluminum oxide. The nanostructure may also be of silicon carbonitride, silicon germanium, titanium nitride, and carbon hardmask. The nanostructure may also be made of compound semiconductors, such as single-crystalline silicon carbide, epitaxial silicon germanium, indium gallium zinc oxide, and wideband semiconductors like GaN, AIN, AlGaN, Ga₂O₃, ZnO, ZnS, CdS. The nanostructure may also be made of EUV MOR that is inorganic and based on metal oxides such as hafnium oxide (HfO₂), zirconium oxide (ZrO₂), or tin oxide (SnO₂). MOR can be deposited by ALD or CVD, or spin-coated. However, other types of materials may as well be used for the nanostructure.

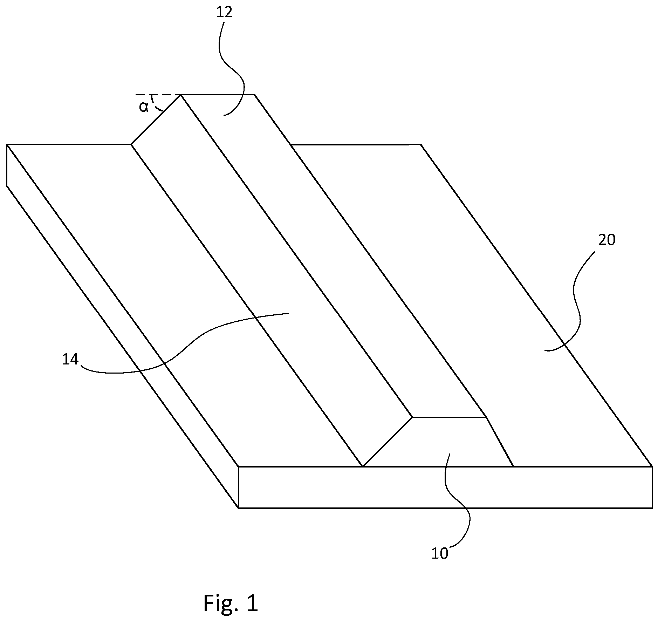

An example of a nanostructure 10 to be exposed to the processing of the present invention is schematically illustrated in connection with Fig. 1. An inclination angle α for the inclined surfaces 14 in relation to the main surface 12 is in this example 60°. It is however to be realized that the processing of the nanostructure as discussed herein may be made on a nanostructure having different geometries, this as long as the nanostructure exhibits a main surface limited by inclined surfaces. The inclination angle α for the inclined surfaces 14 in relation to the main surface 12 is to be larger than 10°, preferably larger than 20°. In Fig. 1, an inclination angle α of 60° is presented. However, other inclination angles may be used, such as 90°. Further, the inclination angle may be different for the different inclined surfaces of the nanostructure.

The nanostructure 10 is preferably arranged on a support structure 20. The support structure 20 is typically planar.

The support structure 20 may be formed of polymer, such as polysiloxanes or polysilazanes. Additionally, the support structure may be formed of silicon, silicon nitride, silicon oxide, silicon carbide, any low-k dielectric such as silicon oxynitride, or any high-k dielectric layer, such as hafnium oxide, zirconium oxide, titanium oxide, tantalum oxide, or aluminum oxide. The support structure may also be of compound semiconductors, such as single-crystalline silicon carbide, epitaxial silicon germanium, indium gallium zinc oxide, and wideband semiconductors like GaN, AIN, AlGaN, Ga₂O₃, ZnO, ZnS, CdS. The support structure 20 may comprise a stop layer. The stop layer may be formed of SiNₓ materials, such as Si3N4, silicon carbonitride, silicon oxynitride, silicon germanium, titanium nitride, and carbon hardmask. However, other types of materials may as well be used.

The nanostructure 10 is a 3D structure. The nanostructure 10 is erecting from the planar support structure 20. The portion of the nanostructure 10 erecting from a support structure 20 is exhibiting the main surface and the inclined surfaces 14. The main surface is typically parallel to the support structure 20. The inclined surfaces 14 are extending from the main surface 12 down to a top surface of the support structure 20.

In Fig. 1 a single nanostructure is illustrated, it is, however, to be understood that a plurality of nanostructures may be exposed to the process of the present invention simultaneously. Such plurality of nanostructures is preferably arranged on a same support structure 20. According to one example, such a plurality of nanostructures is arranged in an array, preferably with a known pitch. If so, after the array of nanostructures having been exposed to the inventive method a pitch split has been performed.

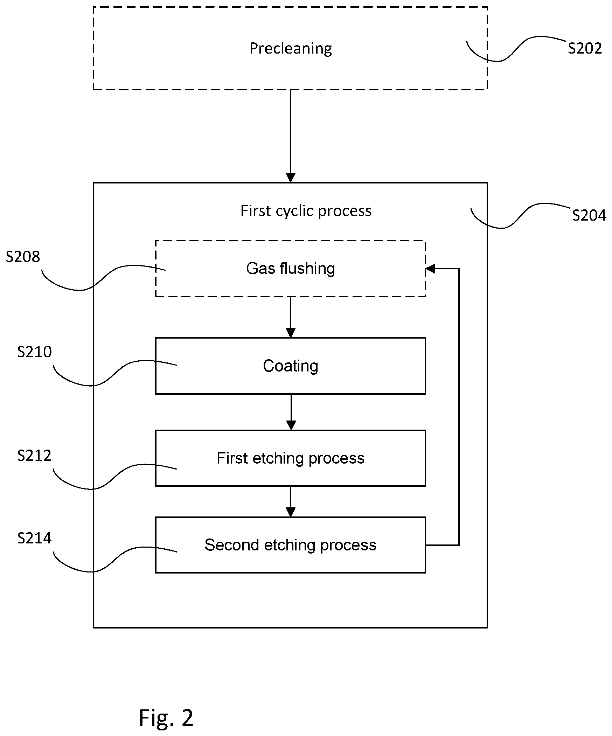

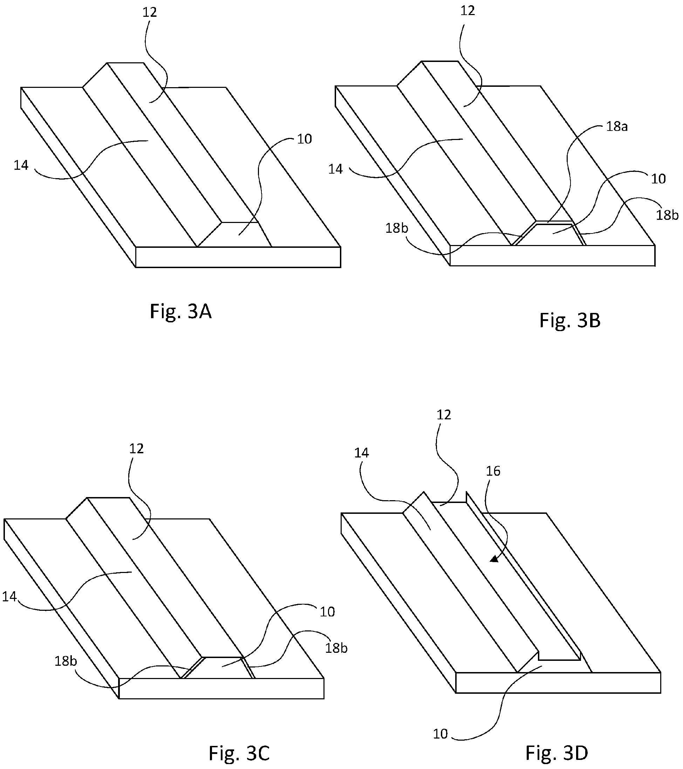

In connection with Fig. 2 and Figs 3A-G a method for processing a nanostructure 10 will be discussed. The nanostructure 10 having a main surface 12 delimited by, in relation to the main surface 12, inclined surfaces 14. Such a nanostructure 10 arranged on a support structure 20 is illustrated in Fig 3A.

The method comprises subjecting the nanostructure for a first cyclic process S204. A number of cycles in the first cyclic process S204 may vary depending on various factors such as a thickness of the nanostructure 10, processing parameters of the process steps in the first cyclic process S204, and the type of process steps in the first cyclic process S204. Typically, the number of cycles in the first cyclic process S204 may vary in the range of 1 to 200 cycles.

Each cycle of the first cyclic process S204 comprises coating S210 the main surface 12 and the inclined surfaces 14 with a coating layer 18a, 18b. The result of a first such coating S210 step is illustrated in Fig. 3B.

Each cycle of the first cyclic process S204 further comprises applying a first etching process S212 configured to anisotropically etch the coating layer 18a from the main surface 12 while at least partly preserving the coating layer 18b on the inclined surfaces 14, thereby exposing the main surface 12 of the nanostructure 10. The result after a first such first etching process S212 is illustrated in Fig. 3C. Here, it can be seen that the coating layer 18a of the main surface 12 has been etched away.

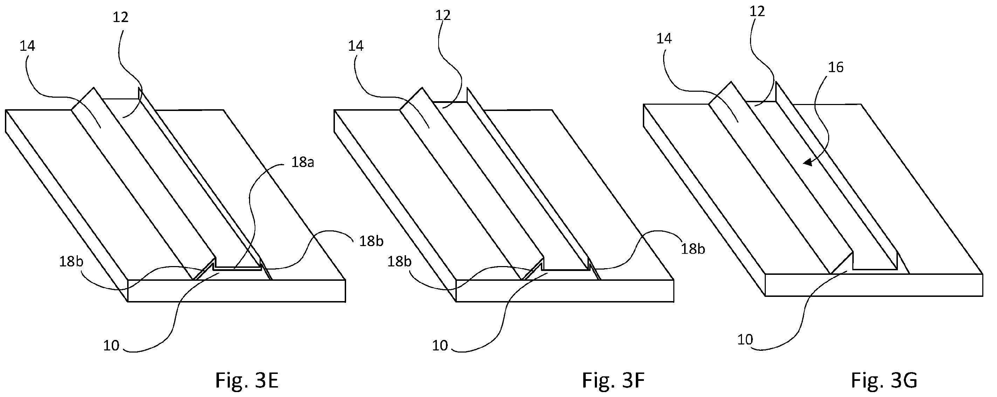

Each cycle of the first cyclic process S204 further comprises applying a second etching process S214 configured to selectively etch the exposed main surface 12 of the nanostructure 10 using the coating layers 18b of the inclined surfaces 14 as masking layers. As a result, selective etching of the main surface 12 of the nanostructure 10 relative to the inclined surfaces 14 of the nanostructure 10 is achieved. This will form a recess 16 in the nanostructure 10. The recess 16 having its opening at the main surface 12 of the nanostructure 10. The result after a first such second etching process S214 is illustrated in connection with Fig. 3D. In Fig. 3D a recess 16 is formed at the main surface 12 of the nanostructure 10. Although the second etching process S214 is configured to selectively etch the exposed main surface 12 of the nanostructure 10 using the coating layers 18b of the inclined surfaces 14 as masking layers, the coating layers 18b of the inclined surfaces 14 will typically also be affected by the second etching process S214 and in the end be substantially etched away. This is what is illustrated in Fig 3D, where the coating layers 18b of the inclined surfaces 14 have disappeared. Once this has occurred, or, preferably, a little before that, while the coating layers 18b of the inclined surfaces are still uniformly covering the sidewalls 14 but this coating layer is already very thin and at risk of being fractured by further processing, it is time to start a new cycle of the first cyclic process S204. A second cycle of the first cyclic process S204 is illustrated in connection with Figs 3E-G. As illustrated in Fig 3E a new coating layer 18a, 18b is formed on the main surface 12 and the inclined surfaces 14 by again coating S210 the main surface 12 and the inclined surfaces 14. The result after applying another step of the first etching process S212 is illustrated in connecting with Fig 3F. Here, it is illustrated that the coating layer 18a on the main surface 12 of the nanostructure 10 again has been etched away. The result after applying another step of the second etching process S214 is illustrated in connecting with Fig 3G. Here it is illustrated that the recess 16 is even deeper than before.

Hence, the present processing of a nanostructure 10 provides selective etching such that a recess 16 in the nanostructure 10 is formed. The recess 16 having its opening at the main surface 12 of the nanostructure 10.

Upon the nanostructure 10 being an elongated structure, the recess 16 may form a channel in the elongated nanostructure. However, by continuing the first cyclic processing S204 with additional cycles, the recess 16 may form a through hole in the elongated nanostructure 10, splitting the elongated nanostructure 10 in two.

Applying the first etching process S212 is performed after, preferably directly after, the coating S210. Applying the second etching process S214 is performed after, preferably directly after, applying the first etching process S212.

The coating S210 is preferably performed using atomic layer deposition (ALD) or chemical vapor deposition (CVD), or other thin film coating techniques. The coating S210 is made by a material selected from the group of materials comprising, for example, of silicon oxide, TiO₂, TaN, TaON, Al₂O₃, HfO₂, ZrO₂, silicon nitride (e.g. Si₃N₄), silicon carbonitride, amorphous silicon, silicon oxycarbide, silicon oxychloride, silicon oxyfluoride, and polymers, such as fluorocarbon, boron-rich fluorocarbon, chlorocarbon, boron-reach fluorocarbon or hydrocarbon, chlorinated or boron-doped hydrocarbon polymer, or a combination thereof. ALD or CVD of such materials is well known by the person skilled in the art. Taking coating S210 with SiO₂ as an example, such coating S210 may be made using bis(diethylamino)silane as a precursor (e.g., SAM.24 from Air Liquide) and O₂-plasma. Taking coating S210 with Al₂O₃ as an example, such coating S210 may be made using trimethyl aluminum, as a precursor and H₂O vapor as a co-reactant in thermal ALD, or alternatively by using aluminum tri-isopropoxide as a precursor and O₂-plasma as a co-reactant in plasma-assisted ALD. Atomic layer deposition provides a very precise control of the deposited layer as a function of the number(s) of process cycles. Further, atomic layer deposition provides a uniform coating to be made.

The forming of the coating layer 18a, 18b on the main surface 12 and the inclined surfaces 14, i.e. the ALD, is to be performed such that all surfaces of the nanostructure 10 erecting from the support structure 20 comprise a coating layer.

The first cyclic process S204 can be performed in any specialized plasma etch system which can also perform atomic layer deposition or chemical vapor deposition or any other thin film deposition. Equipment from for instance Plasway-Technologies GmbH, e.g., a single-reactor chamber FALP system, or a special reactor for combining ALD and etch processes can be used to implement this process. A dual reactor chamber system, with separate ALD and ALE chambers is preferred over a single-reactor chamber system to avoid reactant cross-contamination.

In the beginning of a cycle, preferably each cycle, of the first cyclic process S204, the processing chamber is flushed S208 with a gas. The gas is preferably oxygen or an inert gas preferably argon or a mixture thereof. This purges any gases and reaction by-products that may have stayed in the chamber from previous steps. Such flushing S208 with gas of the processing chamber prepares the chamber and the equipment therein for the subsequent steps. Typical process parameters for flushing S208 with gas are: duration 0.001-30 seconds. Alternatively, this step may be even omitted. This step may be performed at 0.01-100 mTorr, preferably 0.1-3 mTorr, process pressure, with a gas flow of 10-200 sccm, preferably 30-50 sccm. As readily understood, these processing parameters depend on the process chamber volume. Preferably, no plasma is applied in the process chamber volume during the gas flushing S208.

Further, before starting the first cyclic process S204, the nanostructure 10 and possibly also the support structure 20 it is arranged on, may be pre-cleaned. Hence, the method may comprise a step of preclearing S202. Such a pre-cleaning S202 may comprise exposing the nanostructure 10 (and possibly also the support structure 20 it is arranged on) for a plasma or chemical treatment. This is in order to achieve a nanostructure 10 (and possibly also a support structure 20 it is arranged on) which is free of contaminants and native oxides. For native oxide removal a buffered oxide etch (10:1 volume ratio of 40% NH₄F to 49% HF) can be performed by, for example, immersing the substrate into a buffered HF solution for 30 seconds, followed by 30 seconds of rinsing in deionized water and dry blowing with N₂ for 15 seconds.

We will now discuss the first and second etching processes S212, S214 in more detail. First and foremost, the first etching process S212 and the second etching process S214 are different etching processes. Herein "different etching processes" means that at least one processing parameter in an etching process is altered transitioning from the first etching process S212 to the second etching process S214. Importantly to note is that the first etching process S212 is configured to anisotropically etch the coating layer 18a from the main (lateral) surface 12 of the nanostructure 10 while preserving the coating layer 18b on the inclined surfaces 14 of the nanostructure 10 and that the second etching process S214 is configured to selectively etch the exposed main surface 12 of the nanostructure 10 using the coating layers 18b on the inclined surfaces 14 of the nanostructure 10 as masking layers. Below some different scenarios of the first and second etching processes S212, S214 will be discussed.

According to a first example, reactive ion etching is used for both the first etching process S212 and the second etching process S214. However, the kinetic energy of the ions being different for the two processes, or the gas mixture being different for the two processes, or both. Reactive ion etching is typically a continuous etch mode. According to this first example, the first etching process S212 is performed by reactive ion etching using ions having a first kinetic energy upon impinging the nanostructure 10 and the second etching process S214 is performed by reactive ion etching using ions having a second kinetic energy upon impinging the nanostructure 10. The second kinetic energy is lower than the first kinetic energy. Preferably, the ions impinging the nanostructure in the second etching process S214 have a kinetic energy below 1 eV, preferably below 0.1 eV. This ensures that the coating layer remaining on the inclined and vertical surfaces is not etched significantly during this process and can act as an efficient etch mask for selectively etching the exposed main surface 12 of the nanostructure 10 after the coating layer is selectively removed from horizontal surfaces during the first etching process S212. The ion energy and directionality for the first etching process S212 is preferably significantly higher than for the second etching process S214. This ensures the directionality of the etching process (anisotropic etching) and, therefore, selective etching of the coating layer from horizontal surfaces, i.e. the main surface 12 of the nanostructure 10. At the same time, the ion energy for the first etching process should not be too high. This is to ensure that the etch rate stays relatively small so that it is practically possible to stop the etch process when the coating layer is completely etched from horizontal surfaces and while it still remains as a continuous film on the inclined surfaces. It is important to stop the second etching process S214 before the coating layer(s) 18b on the inclined surface(s) 14 becomes discontinuous. Importantly, the ion energy must stay well below the physical sputtering threshold. This is because this physical sputtering is more efficient on inclined surfaces and will work against selective etching of the coating layer from horizontal surfaces. Further, also the line edge roughness and line width roughness may be controlled in this way. The exact values will depend on the other process details, first of all, on the process gas mixture and process temperature. The process is typically performed at temperatures in the range from -120°C up to 300°C, preferably -120°C up to 35°C. Other temperatures can be also used.

The ions in the reactive ion etching of the first etching process may be formed from ionized SF₆ gas contained in a gas mixture supplied to the process chamber volume. The ionization of the gas may be done using plasma generated by applying 13.56 MHz and 0.1-30 W, preferably 10-20 W, radiofrequency power to the electrode on which the nanostructure is placed. The ions in the reactive ion etching of the second etching process may be formed from ionized SF₆ gas contained in a gas mixture supplied to the process chamber volume. The ionization of the gas may be done using plasma generated by applying 13.56 MHz or 2 MHz and 0.1-3000 W, preferably 1000-3000 W, radiofrequency power inductively or transformer coupled to the processing chamber in which the processing of the nanostructure is performed. According to this first example, typical process parameters for the first etching process S212 are: duration 0.00001-300 seconds, preferably 0.1-30 seconds, at 0.01-20 mTorr, preferably 0.01-5 mTorr, process pressure, and 1-200 sccm, preferably 5-50 sccm, SF₆ gas flow. According to this first example, typical process parameters for the second etching process S214 are: duration 0.00001-300 seconds, preferably 0.1-30 seconds, at 0.01-100 mTorr, preferably 1-50 mTorr, process pressure, and 1-200 sccm, preferably 5-50 sccm, SF₆ gas flow. The exact process parameters will depend on the process chamber design and processed sample size and geometry, and process temperature. The typical wafer size in high volume manufacturing of leading-edge semiconductors is 300 mm, however, other wafer sizes can also be used, for example, 200 mm wafers are also quite common.

According to a second example, the first etching process S212 is performed using reactive ion etching and the second etching process S214 is performed using a second cyclic etching process, where each cycle comprises surface modification and surface activation removal. The reactive ion etching of the first etching process S212 may be performed using ionized SF₆ gas contained in a gas mixture supplied to the process chamber volume. After having completed the reactive ion etching of the first etching process S212 the coating layer 18a, 18b of the nanostructure 10 has been anisotropically etched such that the coating layer 18a on the main surface 12 of the nanostructure 10 is etched away and the coating layer(s) 18b on the inclined surfaces 14 has been preserved. The cycles of the second cyclic etching process comprise a step of surface modification and a step of surface activation removal. The surface modification may be performed by introducing chemical species in the process chamber volume enclosing the nanostructure 10. The chemical species may be halogens or halogen-containing species (e.g. CHF₃, CHCl₃). The surface modification may be done in a gas phase that contains only neutral chemical species. More specifically, the surface modification may be made by the chemisorption of chlorine. The surface modification may be followed by an evacuation of excessive chemical species from the process chamber volume. The surface activation removal may be made by impinging the nanostructure 10 with noble gas ions. Preferably, argon ions are used. Typically, an average kinetic energy of the argon ions impinging the nanostructure 10 is set to be 40 eV to 60 eV, at least in the case of the nanostructure 10 being made from silicon. A number of cycles of the second cyclic etching process in this example of the second etching process S214 depend on the process selectivity of etching the material of the nanostructure 10 as compared to the coating layer(s) 18b on the inclined surfaces 14. It is preferred to stop the second etching process S214 before the coating layer(s) 18b on the inclined surface(s) 14 becomes discontinuous. An end point detection can be used for this, for example, optical emission spectroscopy (OES). Alternatively, an etch stop layer can be used for this. During the second etching process S214 material from the main surface 12 of the nanostructure is etched away while preserving at least some of the coating layer 18b on inclined surface(s) 14.

According to one example upon the nanostructure is made from silicon and the coating layer is made from SiO₂, typical process parameters for the second cyclic etching process of the second etching process S214 are: 1-30 cycles, 0.1-300 seconds, preferably 0.1-30 seconds, for each step of the cyclic process, at 0.01-100 mTorr, preferably 0.01-60 mTorr, process pressure, 1-200 sccm, preferably 5-30 sccm, Cl₂ gas flow; and 1-200 sccm, preferably 5-30 sccm, Ar gas flow. The process pressure for the chlorination step is preferred to be 30-60 mTorr. This chlorination step is typically done without the application of any radiofrequency power to the electrode on which the nanostructure is positioned. The radiofrequency power inductively or transformer coupled to the chamber is preferred to be in the range 500-1500 W, preferably 900-1100 W. The process pressure for the activation step with Ar bombardment is preferred to be 1-5 mTorr. This activation step is typically done with very small radiofrequency power applied to the electrode on which the nanostructure is positioned. This power is usually adjusted to have the average Ar ion energy between 40 to 60 eV, typically corresponding to 0-20 W applied power. The radiofrequency power inductively or transformer coupled to the chamber during this step is preferred to be 100-500 W, preferably 200-300 W. The exact process parameters will depend on the process chamber design and processed sample size and geometry.

For other combinations of nanostructures and coating layers different processing parameters may be optimal.

The processing of a nanostructure 10 according to the present invention may be used for assisting different lithographic and patterning techniques, including but not limited by deep ultraviolet lithography (DUV), extreme ultraviolet lithography (EUV), nanoimprint lithography (NIL), self-aligned multiple patterning (SAMP). This processing assists these techniques by splitting the pitch of structures made with these techniques, in this way providing a means to manufacture and even scale down different nanoscale devices in a cost-efficient way. This way, the process can be used for manufacturing of different nanoscale devices, which can also be produced with the other lithographic and patterning techniques. According to a non-limiting example, the processing may be used for recessing FinFET gate channels. According to another non-limiting example, the processing may be used for forming and/or modifying a transistor gate channel, such as the nanowire gate channels in a Gate-All-Around (GAA) FET or complementary FET (CFET).

The person skilled in the art realizes that the present invention by no means is limited to what is explicitly described above. On the contrary, many modifications and variations as well as semiconductor device types are possible within the scope of the appended claims.

For example, the surface modification and/or the surface activation removal of any one of the cyclic processes discussed above may include a self-limiting reaction that slows down or stops as a function of time or, equivalently, as a function of species dosage. Such a self-limiting reaction comprises chemisorption, deposition, extraction, and/or conversion such as oxidation or nitridation.

Upon executing the method for processing a nanostructure, process control information, including endpoint detection, may be monitored by e.g. optical emission and residual gas analysis. Process parameters of the method may then be adjusted based on the process control information.

The method for processing a nanostructure may be repeated until the processing has no further effect on the nanostructure. For example, a fin-type silicon nanostructure may be split into two fin-type silicon nanostructures. The two newly formed fin-type silicon nanostructures being thinner that the starting fin-type silicon nanostructure.

In connection with the evacuation of excessive chemical species from the process chamber volume discussed above for the various embodiments/examples this may be performed by alternating pumping the process chamber to low pressure and flashing the process chamber with a gas at a relatively high pressure or with energetic light pulses (like synchronized flash lamp annealing as used in Rapid Thermal Processing). This alternation may be done several times to assist in the fast removal of the species remaining in the process chamber. The pumping is preferably done to a chamber pressure below 0.1 mTorr. The purging is preferably made by an inert gas or an inert gas containing gas mixture. As an option, the purging may comprise hydrogen, which removes excessive oxygen from the process chamber. The chamber pressure during the purging is preferably above 10 mTorr, more preferably above 50 mTorr. The optimal purging pressure depends on the pumping capacitance of the specific etch system.

The coating S210 and the first etching process S212 may be separated with a step for evacuation of excessive gases from the process chamber volume. This may be performed by alternating pumping the chamber to low pressure and purging the process chamber with a gas or a gas mixture. This alternation may be done several times to assist in the fast removal of the species remaining in the process chamber. The pumping is preferably done to a chamber pressure below 0.1 mTorr. The purging is preferably made by an inert gas or an inert gas containing gas mixture. As an option, the purging may comprise hydrogen, which removes excessive oxygen from the process chamber. The chamber pressure during the gas purge is preferably above 10 mTorr, more preferably above 50 mTorr. The optimal purging pressure depends on the pumping ability of the specific etch system.

One important aspect of the practical realization of this process is to make it stable for throughout all the cycles despite varying process parameters. One way of doing this is to keep plasma on all the time through all the steps and all the cycles. This enables more stable plasma, as the plasma ignition is usually a reason for instabilities, and it can take substantial time to stabilize the plasma after its ignition. Another important aspect of keeping the process stable is to minimize the process pressure variation, ideally performing all the steps in the cycle at the same or similar pressure.

It is further realized that by exposing a nanostructure which is not elongated but has a substantially square extension exhibiting a substantially planar top surface limited by inclined surfaces, a box structure may be formed. Also, nanostructures that exhibit a circular, a triangular, or having any geometric shape top surface may be processed using the herein disclosed processing of a nanostructure.

Additionally, variations can be understood and effected by the skilled person in practicing the claimed invention, from a study of the drawings, the disclosure, and the appended claims.

## Claims

1. A method for splitting a 3D nanostructure (10) erecting from a planar support structure (20), the portion of the nanostructure (10) erecting from a support structure (20) having a main surface (12) delimited by, in relation to the main surface (12), inclined surfaces (14) extending from the main surface (12) to a top surface of the support structure (20), the method comprising:
subjecting the nanostructure (10) for a first cyclic process where each cycle comprises:
coating (S210) the main surface (12) and the inclined surfaces (14) with a coating layer (18a, 18b);
applying a first etching process (S212) configured to anisotropically etch the coating layer (18a) from the main surface (12) while preserving the coating layer (18b) on the inclined surfaces (14), thereby exposing the main surface (12) of the nanostructure (10); and
applying a second etching process (S214) configured to selectively etch the exposed main surface (12) of the nanostructure (10) using the coating layers (18b) of the inclined surfaces (14) as masking layers;
whereby selective etching of the main surface (12) relative to the inclined surfaces (14) is achieved such that a recess (16) in the nanostructure (10) is formed, the recess (16) having its opening at the main surface (12) of the nanostructure (10).

2. The method according to claim 1, wherein the coating (S210) is performed using atomic layer deposition or chemical vapor deposition.

3. The method according to claim 1 or 2, wherein the coating (S210) is made by a material selected from a group of materials consisting SiO₂, Al₂O₃, HfO₂, ZrO₂, silicon nitride and polymers such as fluorocarbon, boron-rich fluorocarbon, chlorocarbon, boron-carbon or hydrocarbon, chlorinated or boron-doped hydrocarbon polymer, or a combination thereof.

4. The method according to any one of claims 1-3,
wherein the first etching process (S212) is performed by reactive ion etching with ions having a first kinetic energy upon impinging the nanostructure (10), and
wherein the second etching process (S214) is performed by reactive ion etching with ions having a second kinetic energy upon impinging the nanostructure (10), wherein the second kinetic energy is lower than the first kinetic energy.

5. The method according to any one of claims 1-3,
wherein the first etching process (S212) is performed by reactive ion etching with ions having a first kinetic energy upon impinging the nanostructure (10); and
wherein the second etching process (S214) is a second cyclic etching process, where each cycle comprises:
surface modification by introducing chemical species in a process chamber volume enclosing the nanostructure (10), and
surface activation removal by noble gas ion bombardment having a third kinetic energy.

6. The method according to claim 5, wherein the noble gas is argon, wherein the third kinetic energy is an average kinetic energy of 40 eV to 60 eV.

7. The method according to claim 5 or 6, wherein the surface modification is done in a gas phase that contains only neutral chemical species.

8. The method according to any one of claims 5-7, wherein the surface modification is done by chemisorption of chlorine.

9. The method according to claims 5-8, wherein the surface modification is followed by evacuating excessive chemical species from the process chamber volume.

10. The method according to any one of claims 4-9, wherein the reactive ion etching is done using ionized SF₆ gas.

11. The method according to any one of claims 1-3, wherein the first etching process is performed by etching with a first type of ions impinging the nanostructure (10), and the second etching process is performed by etching with a second type of ions impinging the nanostructure (10), wherein the first and second types of ions are different types of ions.

12. The method according to any one of claims 1-11, wherein at least a portion, preferably each, of the cycles of the first cyclic process (S204) further comprises purging a process chamber volume used for the processing of the nanostructure by flushing (S208) the process chamber volume with a gas mixture, preferably containing oxygen or an inert gas, preferably argon, or a mixture thereof.

13. The method according to claim 12, wherein the flushing (S208) is performed for 0.1-30 seconds at 0.01-100 mTorr, preferably 0.1-3 mTorr, process pressure, and at 10-200 sccm, preferably 30-50 sccm, gas flow.

14. The method according to any one of claims 1-13, wherein the nanostructure (10) is arranged on a support structure (20), wherein the support structure is preferably formed of silicon, silicon nitride, silicon oxide, silicon carbonitride, or silicon oxynitride.

15. The method according to any one of claims 1-14, wherein the nanostructure (10) is made from a material selected from a group of materials consisting silicon, silicon nitride, silicon oxide, amorphous carbon, and polymers, such as polysiloxanes or polysilazanes or any photosensitive or electron beam sensitive polymer or a polymer used for printing in nanoimprint lithography or EUV Metal Oxide resist.
